Europäisches Patentamt

European Patent Office

Office européen des brevets

(19)

(11) Numéro de publication : **0 470 915 A1**

## (12) DEMANDE DE BREVET EUROPEEN

(21) Numéro de dépôt : **91420287.4**

(51) Int. Cl.$^5$ : **G01R 33/04**

(22) Date de dépôt : **01.08.91**

(30) Priorité : **02.08.90 FR 9010089**

(43) Date de publication de la demande :
**12.02.92 Bulletin 92/07**

(84) Etats contractants désignés :
**AT BE CH DE FR GB IT LI NL SE**

(71) Demandeur : **Le Thiec, Philippe**
**1, Boulevard Clémenceau**
**F-38000 Grenoble (FR)**

(72) Inventeur : **Le Thiec, Philippe**
**1, Boulevard Clémenceau**
**F-38000 Grenoble (FR)**

(74) Mandataire : **de Beaumont, Michel**
**1bis, rue Champollion**
**F-38000 Grenoble (FR)**

(54) **Capteur de champ magnétique à haute sensibilité.**

(57)   La présente invention concerne un capteur de champ magnétique à haute sensibilité comprenant : un circuit magnétique à haute perméabilité (10) et des moyens d'excitation ($L_e$) permettant de saturer périodiquement ce circuit magnétique ; deux bobinages identiques ($L_1$, $L_2$) bobinés symétriquement autour de parties symétriques (A, B) du circuit magnétique ; un premier et un second condensateur identiques ($C_1$, $C_2$), respectivement connectés aux bornes de chacun des bobinages ; et des moyens ($L_1$, $L_2$ ; $L_3$) de mesure de la différence des flux magnétiques traversant lesdites parties.

FIG. 2A

La présente invention concerne le domaine des capteurs de champ magnétique, magnétomètres ou gradientmètres.

A l'heure actuelle, dans le domaine de la détection des champs magnétiques ou des masses magnétiques, on connaît des capteurs relativement précis et performants à haute sensibilité tels que les magnétomètres à résonance magnétique nucléaire ou les magnétomètres à supraconducteur fonctionnant à l'hélium liquide.

Un inconvénient évident de ce type de magnétomètre réside dans leur coût très élevé et, en outre, en ce qui concerne les magnétomètres à supraconducteur, dans leur durée de vie limitée (il n'est pas possible de maintenir pendant une très longue durée et dans des conditions d'utilisation courantes des températures suffisamment basses pour le fonctionnement d'un supraconducteur).

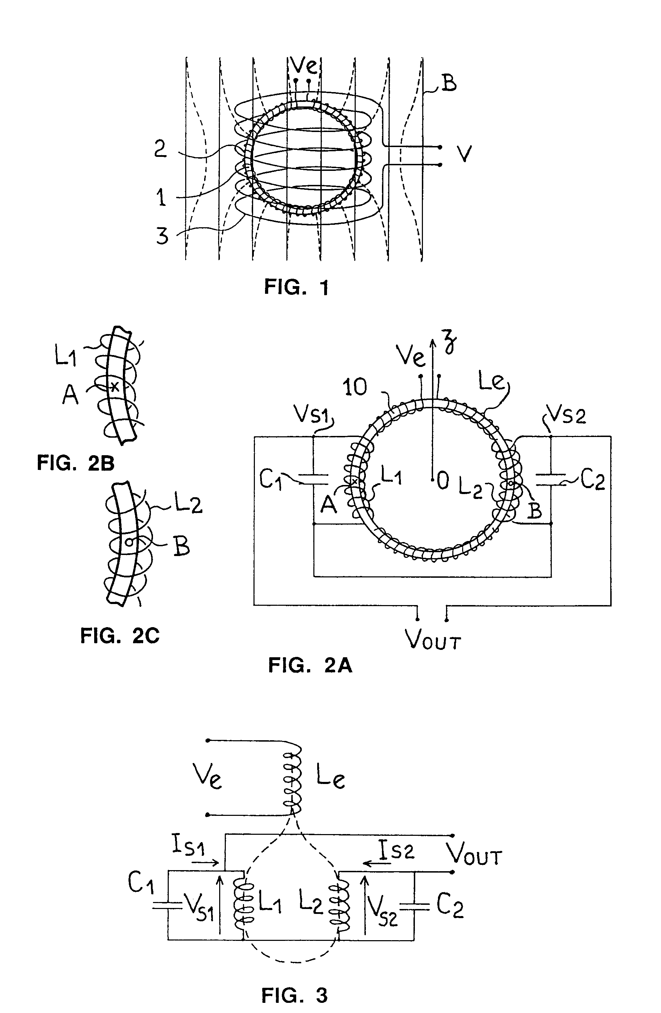

Ainsi, on utilise actuellement de façon courante des magnétomètres de type "fluxgate" dont la structure et le fonctionnement vont être rappelés en relation avec la figure 1 et qui présentent l'avantage d'un coût relativement raisonnable. En effet, il faut garder en mémoire que les magnétomètres, directionnels ou non-directionnels, sont couramment utilisés pour détecter des variations du champ magnétique terrestre liées à la présence ou au passage d'objets métalliques ou de sources de champ magnétique et doivent alors être déployés en grand nombre.

La figure 1 illustre très schématiquement un magnétomètre du type fluxgate pour en expliquer le principe de fonctionnement. Un tel magnétomètre, destiné à être placé dans un champ magnétique B, comprend un noyau magnétique saturable 1 de perméabilité magnétique élevée. Un enroulement 2 alimenté par une tension d'excitation alternative Ve permet d'amener périodiquement le noyau magnétique à l'état de saturation.

Quand le noyau magnétique est saturé, le champ magnétique B n'est sensiblement pas perturbé par ce noyau et les lignes de champ sont, par exemple, droites comme cela est représenté par les lignes en traits pleins de la figure 1. Par contre, quand le noyau magnétique n'est pas saturé, les lignes de champ se resserrent pour passer préférentiellement dans ce noyau magnétique en raison de sa perméabilité élevée. Ces lignes de champ sont représentées par des traits en pointillés en figure 1.

Un enroulement détecteur 3 placé au voisinage du noyau 1 créant la perturbation dans le champ magnétique sera source d'une tension V dont la fréquence fondamentale correspond à la fréquence d'excitation, cette tension étant caractéristique des variations du flux traversant l'enroulement 3 et donc indirectement de la valeur du champ B dans lequel est placé le dispositif. Dans la figure, l'enroulement détecteur 3 a été représenté comme encerclant le noyau saturable 1. Ceci est possible, puisque l'effet des spires opposées de l'enroulement d'excitation 2 s'annule. On notera toutefois que l'enroulement de détection pourrait être disposé à un autre emplacement dans le champ.

De tels magnétomètres de l'art antérieur sont de structure relativement simple mais présentent l'inconvénient d'une faible sensibilité, qui ne dépasse pas 100 microvolts/nT. Du fait de cette faible sensibilité, on est amené à utiliser un enroulement détecteur haut et à grand nombre de spires. Il en résulte, si le champ à mesurer n'est pas homogène, une erreur de mesure liée à l'influence du gradient de champ (termes non-diagonaux du tenseur gradient).

Ainsi, un objet de la présente invention est de prévoir un capteur de champ magnétique de structure simple et de haute sensibilité.

Un autre objet de la présente invention est de prévoir un magnétomètre dont la précision est peu affectée par d'éventuels gradients de champ.

Un autre objet de la présente invention est de prévoir un capteur de champ magnétique dont la précision est peu affectée par des variations de température et par le vieillissement.

Un autre objet de la présente invention est de prévoir un capteur de champ magnétique pouvant délivrer une information utile didrectement sous forme numérique.

Un autre objet de la présente invention est de prévoir un tel capteur utilisable en gadientmètre de structure simple et de haute sensibilité.

Pour atteindre ces objets, la présente invention prévoit un capteur de champ magnétique à haute sensibilité comprenant un circuit magnétique à haute perméabilité ; des moyens d'excitation permettant de saturer périodiquement ce circuit ; deux bobinages identiques bobinés symétriquement autour de parties symétriques du circuit magnétique ; un premier et un second condensateur identiques, respectivement connectés aux bornes de chacun des bobinages ; et des moyens de mesure de la différence des flux magnétiques traversant lesdites parties.

Selon un mode de réalisation de la présente invention, la capacité des condensateurs est choisie en relation avec la valeur des inductances des bobinages et avec la périodicité du signal d'excitation pour que les deux condensateurs soient chargés par la tension générée aux bornes des bobinages pendant les phases de désaturation du circuit magnétique, que les deux circuits résonants formés par chaque assemblage d'un condensateur et d'un bobinage entrent en oscillations libres pendant les phases de saturation du circuit magnétique, et que les commutations du signal d'excitation surviennent pendant ces oscillations libres tandis que la différence des tensions aux bornes des bobinages s'est inversée par rapport à la commutation précédente.

Les bobinages sont de préférence concentrés vers le plan équatorial du circuit magnétique saturable.

Selon un mode de réalisation de la présente invention, les moyens de mesure comprennent des moyens de détection d'une tension générée par la différence de flux, des moyens de détection synchrone de cette tension fournissant un signal redressé, des moyens d'intégration du signal redressé, et des moyens de réinjection du signal redressé dans les moyens de détection.

Les moyens de détection sont constitués par les bobinages susmentionnés ou par une bobine auxiliaire entourant l'ensemble du circuit magnétique.

Ce capteur présente notamment les avantages suivants : grande sensibilité, grande stabilité à long terme, faible bruit propre, faible consommation de puissance, directionnalité, simplicité de réalisation, excellent rapport performances/prix, bande passante large allant du continu à quelques kilohertz. En outre, comme on le verra, les informations de champ peuvent être disponibles directement sous forme numérique.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1, décrite précédemment, illustre le fonctionnement d'un magnétomètre classique de type fluxgate ;

la figure 2A représente de façon schématique l'élément détecteur d'un magnétomètre selon la présente invention ;

les figures 2B et 2C représentent à plus grande échelle des parties de la figure 2A ;

la figure 3 représente sous forme de schéma électrique le détecteur de la figure 2 ;

les figures 4A-4B, 7A-7B, et 10A-10B représentent des exemples de tensions et de courants susceptibles d'apparaître dans un circuit selon la présente invention, respectivement en l'absence de champ magnétique, en présence de champ magnétique en régime transitoire, et en présence de champ magnétique en régime établi ;

les figures 5, 8 et 11 représentent la façon dont des points du noyau magnétique diamétralement opposés et situés sensiblement dans le plan équatorial parcourent le cycle d'hystérésis dans le cas respectif des figures 4, 7 et 10 ;

les figures 6A-6F, 9A-9F, 12A-12H représentent la façon dont évolue la saturation du noyau magnétique, respectivement dans le cas des figures 4, 7 et 10 ;

la figure 13 représente divers chronogrammes de fonctionnement d'un circuit selon la présente invention ;

la figure 14 représente un détecteur selon la présente invention associé à un circuit de mesure de type analogique ;

la figure 15 représente un détecteur selon la présente invention associé à un circuit de mesure de type numérique ;

la figure 16 représente une variante à bobine auxiliaire du capteur selon la présente invention ; et

la figure 17 représente une variante du capteur selon la présente invention utilisable en gradientmètre.

## STRUCTURE ET FONCTIONNEMENT DU CAPTEUR

La figure 2A représente de façon schématique un détecteur de champ magnétique selon la présente invention. Ce détecteur, d'axe Oz, comprend un circuit magnétique à haute perméabilité 10, de préférence fermé, autour duquel est enroulé un bobinage d'excitation $L_e$. Le bobinage $L_e$ est représenté seulement de façon partielle en figure 2A pour simplifier cette figure. Il reçoit une tension d'excitation $V_e$ périodique d'amplitude suffisante pour placer à chaque période le circuit magnétique 10 dans son état de saturation. Autour du circuit magnétique 10 sont également placés deux bobinages $L_1$ et $L_2$ parallèles et connectés en opposition par rapport au flux d'excitation. Dans le cas où le circuit magnétique a une forme torique et présente un axe de détection Oz, comme cela est représenté, ces bobinages $L_1$ et $L_2$ seront disposés autour de portions équatoriales diamétralement opposées du tore, A et B.

Chacun des bobinages $L_1$, $L_2$ est connecté à un condensateur $C_1$, $C_2$. Les inductances $L_1$ et $L_2$ sont identiques de même que, de préférence, les condensateurs $C_1$ et $C_2$. La valeur des condensateurs $C_1$ et $C_2$ sera explicitée plus en détail ci-après. $V_{s\,1}$ et $V_{s\,2}$ désignent les tensions aux bornes de chacun des circuits résonants et $V_{out}$ la différence entre ces tensions obtenue, par exemple, en interconnectant l'une des bornes des condensateurs $C_1$ et $C_2$ et en analysant la différence de tension entre les deux autres bornes de ces condensateurs, ou bien en utilisant la sortie d'un bobinage supplémentaire de détection du type du bobinage 3 de la figure 1.

Comme l'illustre la figure 3, où les tirets symbolisent le couplage magnétique variable entre les bobinages $L_e$, $L_1$ et $L_2$, tandis que le noyau magnétique change d'état de saturation, par suite des inversions de sens de la tension d'excitation $V_e$ appliquée à l'enroulement d'excitaion $L_e$, il se développe dans les bobinages $L_1$ et $L_2$ des tensions $V_{s\,1}$ et $V_{s\,2}$ et, comme chacune des inductances est fermée sur un condensateur, il circulera dans chacun des circuits $L_1\,C_1$, $L_2\,C_2$ des courants $I_{s\,1}$ et $I_{s\,2}$.

On va examiner ci-après l'évolution de ces tensions et courants en l'absence et en présence de champ magnétique extérieur, en régime transitoire et en régime établi.

### 1. Cas d'un champ magnétique extérieur nul

En l'absence de champ magnétique extérieur, il est clair que, si les inductances et les condensateurs sont respectivement identiques, ces tensions et ces courants seront identiques ; et les bobinages $L_1$ et $L_2$ sont connectés pour que la tension $V_{out}$ soit nulle.

Dans ce cas, pendant une invertion du champ dans le circuit magnétique, les bobinages $L_1$ et $L_2$ seront la source de courants circulant dans un sens propre à s'opposer à cette inversion de champ. Ces courants chargent les condensateurs respectifs $C_1$ et $C_2$. Dès que le circuit magnétique est saturé, il n'y a plus de variation de champ dans les bobinages $L_1$ et $L_2$ ; on se trouve en présence d'un circuit résonant classique à inductance-capacité et les condensateurs se chargent et se déchargent dans les inductances à la fréquence de résonance du circuit résonant.

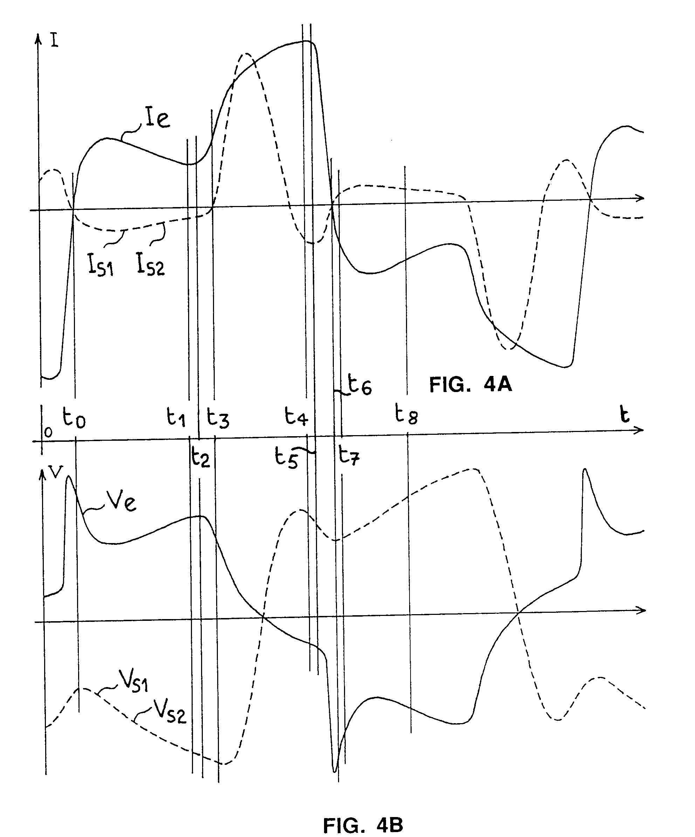

Le fonctionnement du capteur se comprendra mieux en relation avec les figures 4A à 6F. La figure 4A représente l'évolution du courant $I_e$ dans le bobinage d'excitation $L_e$ et du courant $I_s$ dans les bobinages $L_1$ et $L_2$ ($I_s = I_{s\,1} = I_{s\,2}$) et la figure 4B représente l'allure des tensions, $V_e$ étant l'allure de la tension dans l'enroulement d'excitation quand une commande en créneaux $V_{eo}$ lui est appliquée et $V_s = V_{s\,1} = V_{s\,2}$ étant l'allure de la tension dans les bobinages $L_1$ et $L_2$.

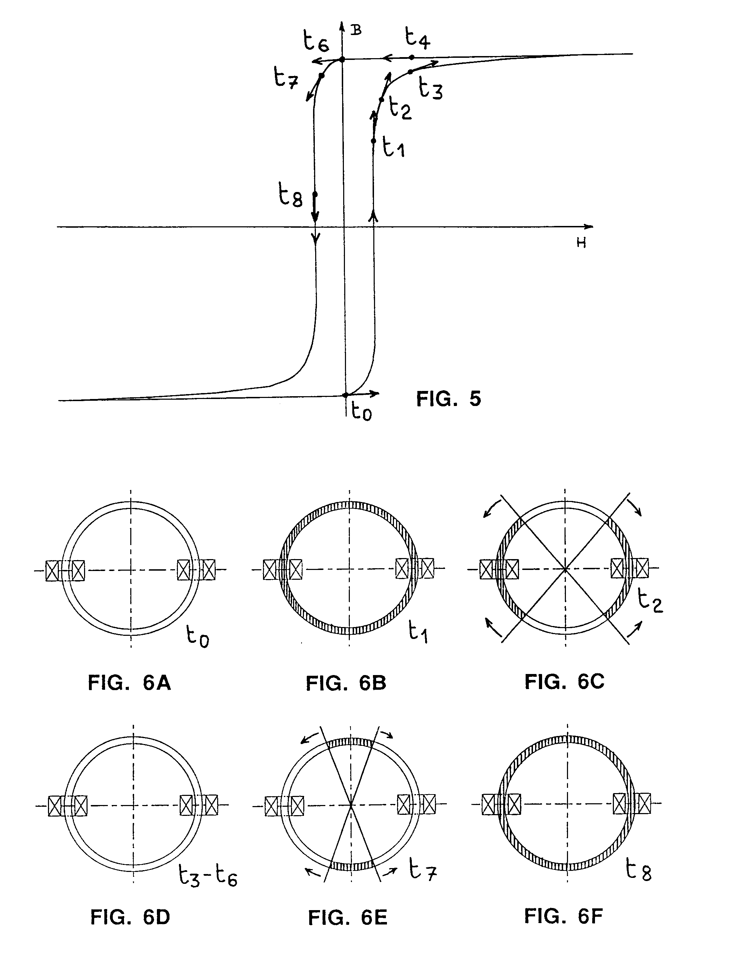

Sur les figures 4A-4B, divers instants $t_0$ à $t_8$ sont indiqués et les états de saturation du noyau magnétique sont représentés de façon correspondante en figures 5 et 6A à 6F. La figure 5 représente un cycle d'hystérésis pour un point situé dans le plan équatorial du capteur, c'est-à-dire à l'intérieur de l'un des bobinages $L_1$ ou $L_2$. Les figures 6A à 6F indiquent l'état magnétique du circuit magnétique 10, les régions non-saturées étant hachurées et les régions saturées laissées en blanc.

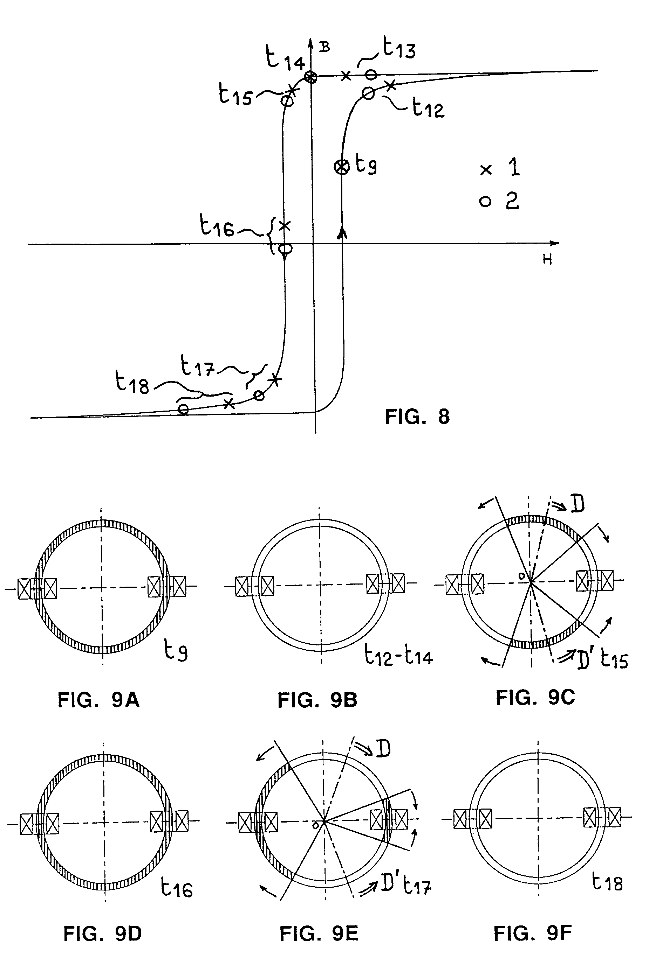

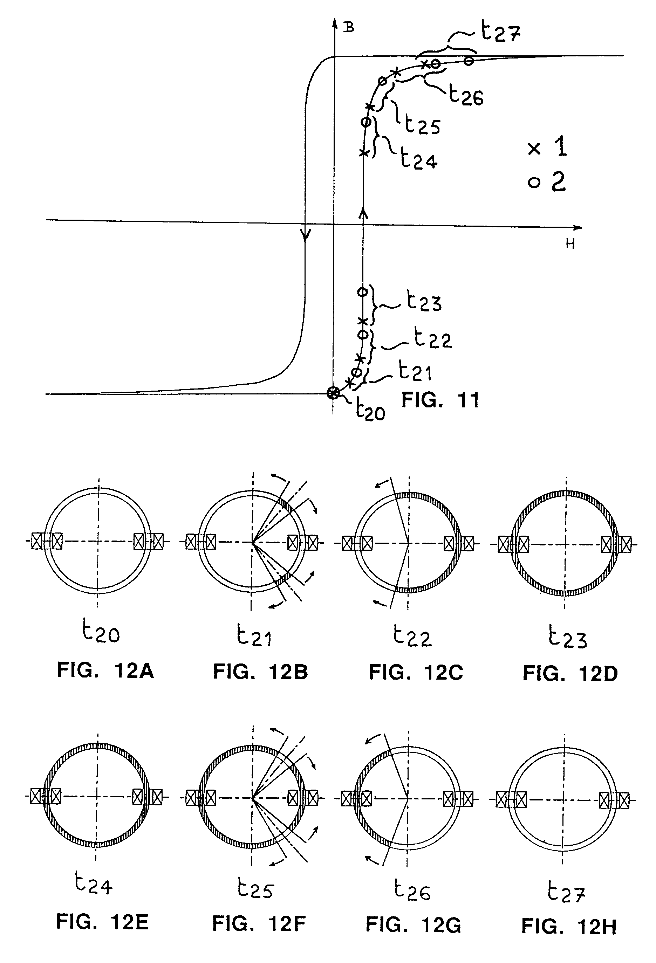

En ce qui concerne le cycle d'hystérésis apparaissant en figure 5 (et les cycles d'hystérésis des figures 8 et 11), on notera que le matériau est non saturé dans les parties verticales du cycle d'hystérésis, et saturé dans les parties horizontales de celui-ci. On appellera coude de saturation positif le coude situé dans le premier quadrant, coude de désaturation positif le coude situé dans le deuxième quadrant, coude de saturation négatif le coude situé dans le troisième quadrant, et coude de désaturation négatif le coude situé dans le quatrième quadrant. Ces appellations supposent que le cycle d'hystérésis est parcouru dans le sens trigonométrique.

A l'instant $t_0$ (figure 6A), l'ensemble du circuit magnétique aborde le coude de désaturation négatif.

Entre $t_0$ et $t_1$, les deux condensateurs $C_1$ et $C_2$ se chargent grâce aux courants démagnétisants dont sont le siège les bobinages $L_1$ et $L_2$. Pendant toute la partie quasi verticale du cycle d'hystérésis précédant $t_1$, le circuit magnétique est désaturé (figure 6B), et le champ $H$ vaut à peu près le champ coercitif $H_c$ du matériau magnétique employé. Le couplage magnétique entre les trois bobinages $L_e$, $L_1$ et $L_2$ est alors maximum.

Au temps $t_2$ (figure 6C), le circuit magnétique arrive au coude de saturation car les courants $I_{s\,1}$, $I_{s\,2}$ ont de moins en moins tendance à s'opposer au courant $I_e$ (ceci car $L_1\,C_1$ et $L_2\,C_2$ forment des circuits oscillants). Progressivement, le secteur désaturé du circuit magnétique diminue, au fur et à mesure que le champ démagnétisant des bobines $L_1$ et $L_2$ diminue. A cet instant $t_2$, les régions polaires du circuit magnétique sont déjà beaucoup plus saturées que les points équatoriaux car, dans ces régions polaires, les champs démagnétisants des bobinages $L_1$ et $L_2$ sont beaucoup plus faibles.

A l'instant $t_3$, (figure 6D) on peut considérer que la totalité du circuit magnétique est saturée ; alors la valeur des inductances $L_1$ et $L_2$ diminue considérablement, ce qui provoque la décharge des condensateurs $C_1$ et $C_2$. Les champs créés par les courants $I_{s\,1}$ et $I_{s\,2}$ vont alors s'ajouter au champ d'excitation $H_e$, contribuant à saturer beaucoup plus le matériau que ne l'aurait fait $H_e$ seul. Ceci est un avantage pour un tel capteur, car cet effet contribue à parfaitement désaimanter le matériau après qu'il ait été soumis, peut être accidentellement, à un champ très fort alors qu'il était hors tension (c'est l'effet de "mémoire" rencontrés sur certains capteurs fluxgate).

Si le courant d'excitation $I_e$ était maintenu suffisamment élevé pour que tout le noyau magnétique reste saturé, alors les deux circuits $L_1\,C_1$ et $L_2\,C_2$ oscilleraient quasi-librement à leur fréquence de résonance, en suivant une sinusoïde amortie exponentiellement.

Sur la figure 4, entre les instants $t_3$ et $t_4$, on observe le début de cette oscillation libre, créant lorsque $I_{s\,1}$ et $I_{s\,2}$ sont positifs des champs $H_1$ et $H_2$ s'ajoutant au champ d'excitation $H_e$.

Si, au temps $t_5$, on commence à inverser la tension d'excitation $V_e$, peu de temps après, au temps $t_6$, le noyau magnétique va approcher du coude de désaturation positif.

A un instant $t_7$ (figure 6E), les zones polaires sont déjà désaturées, alors que les régions équatoriales sont encore saturées, car les courants démagnétisants $I_{s\,1}$ et $I_{s\,2}$ tendent à retarder l'arrivée de ces régions dans la zone désaturée.

A partir de l'instant $t_8$ (figure 6F), l'ensemble du circuit magnétique est de nouveau désaturé, ce qui augmente considérablement le couplage magnétique entre $L_e$ et $L_1$ d'une part, $L_e$ et $L_2$ d'autre part, provoquant la recharge des condensateurs $C_1$ et $C_2$ avec une polarité inverse de celle qui était présente en $t_0$, grâce aux courants démagnétisants $I_{s\,1}$ et $I_{s\,2}$.

A partir de $t_6$, on observe une situation symétrique de celle décrite entre $t_0$ et $t_6$.

## 2. Cas d'un champ magnétique extérieur non nul

### 2.1 Régime transitoire

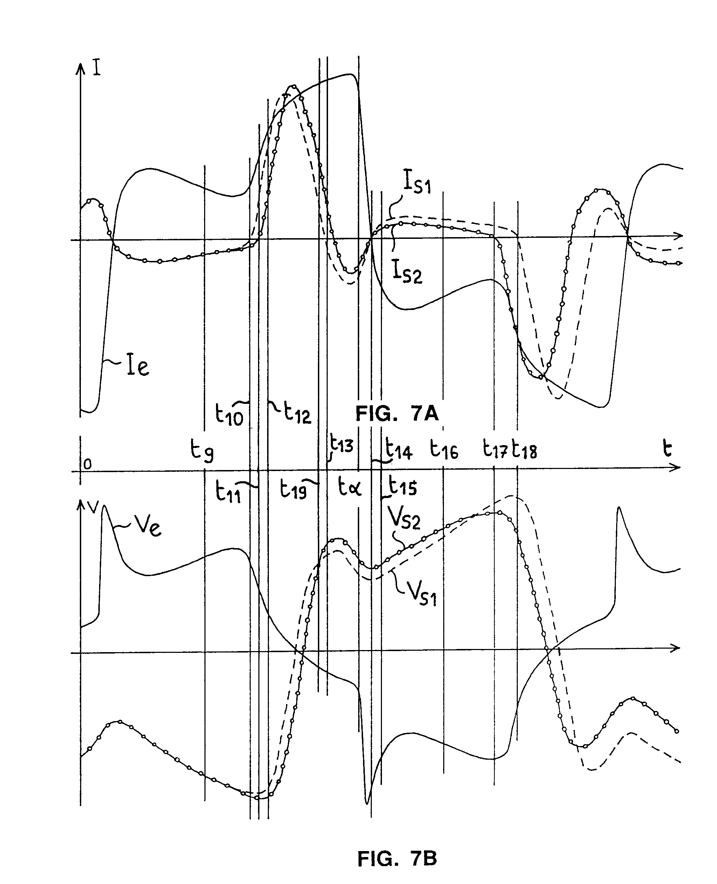

On considère maintenant le cas où, à un instant $t_9$, un champ extérieur $H_0$ non nul est appliqué sur le détecteur (figures 7A-7B, 8, 9A-9F). Dans le cycle d'hystérésis de la figure 8, comme ci-après dans le cycle d'hystérésis de la figure 11, on a symbolisé par une croix un point A du plan équatorial disposé dans le bobinage $L_1$ et par un rond un point B du plan équatorial disposé dans le bobinage $L_2$.

Le champ $H_0$ s'ajoute au champ d'excitation $H_e$ sur l'un des bobinages $L_1$ et $L_2$, tandis qu'il s'en retranche sur l'autre bobinage. Ainsi, la partie du circuit magnétique correspondant à l'un des bobinages $L_1$ et $L_2$ arrivera dans l'état de saturation avant l'autre, c'est-à-dire que l'un des deux circuits résonants passera avant l'autre de la phase de charge du condensateur à la phase d'oscillation.

Supposons que le circuit entrant le premier dans la phase d'oscillation (au temps $t_{10}$) soit $L_1C_1$, et que le circuit $L_2 C_2$ l'entame au temps $t_{11}$.

Comme le condensateur $C_1$ a été chargé pendant moins longtemps que $C_2$, les amplitudes du courant et de la tension de ses oscillations libres sont plus faibles que celles de $C_2$.

Si on abandonnait ce circuit en maintenant le courant d'excitation $I_e$ suffisament élevé pour que tout le noyau magnétique reste saturé, alors les deux circuits $L_1C_1$ et $L_2 C_2$ oscilleraient quasi-librement à leur fréquence de résonance, les deux courants suivant deux sinusoïdes amorties exponentiellement, légèrement déphasées. Si, au début des oscillations libres du circuit $L_1 C_1$, il existe des différences de courants $\delta I(t_{10})$ = $I_{s\,1}(t_{1\,0})-I_{s\,2}(t_{1\,0})$ et de tensions $\delta_1 V(t_{1\,0})=V_{s\,1}(t_{1\,0})-V_{s\,2}(t_{1\,0})$, ces différences vont alternativement croître et décroître.

C'est cette différence de tension qui est indicative du champ extérieur appliqué, et le choix convenable de l'instant de commutation, $t\alpha$, est fondamental pour que la différence de tension intégrée soit maximale.

Si on inverse la tension d'excitation $V_{e\,0}$ à un instant $t\alpha$ où :
* $\delta_1 V(t\alpha)$ s'est inversée par rapport à $\delta_1 V(t_{1\,0})$, et
* $\delta_1 V(t\alpha)$ a été simplifiée par rapport à $\delta_1 V(t_{1\,0})$,
alors, peu de temps après, à l'instant $t_{1\,4}$, les points équatoriaux diamétralement opposés du circuit magnétique vont rentrer dans le coude de désaturation positif, avec une différence de tension de charge des condensateurs $C_1$ et $C_2$ plus grande en valeur absolue qu'au début des oscillations libres, et de polarité inversée.

Au temps $t_{1\,5}$, les bobinages $L_1$ et $L_2$ subissent sensiblement les mêmes variations du flux d'excitation $-d\Phi_e/dt$, mais les tensions qui vont permettre de recharger les condensateurs $C_1$ et $C_2$ sont différentes ; il s'agit sur le circuit $L_1 C_1$, de $V_1(t_{1\,5}) - d\Phi_e/dt$, et sur le circuit $L_2 C_2$ de $V_2(t_{1\,5}) - d\Phi_e/dt$. En conséquence, le courant de charge de $C_1$ qui possédait en $t_{1\,4}$ la tension la plus faible, va être plus élevé que le courant de charge de $C_2$.

En $t_{1\,7}$, le courant $I_{s\,2}$ n'est plus assez grand pour s'opposer à la saturation du point B commandée par le courant d'excitation, et le circuit $L_2 C_2$ entame son oscillation libre. $I_{s\,2}$ augmente alors très rapidement, créant une forte variation de flux au point A, induisant une tension élevée sur $L_1$, tendant à charger $C_1$ jusqu'à $t_{1\,8}$.

En $t_{1\,8}$, le point A devient saturé grâce au courant d'excitation et au courant $I_{s\,2}$, la valeur de l'inductance $L_1$ diminue très rapidement, et c'est $L_1 C_1$ qui entame son oscillation libre.

On doit remarquer que la différence $t_{1\,8}-t_{1\,7}$ est, si les conditions énoncées pour $t\alpha$ sont remplies, supérieure à $t_{1\,1}-t_{1\,0}$.

Pendant la demi-période suivante, les mêmes phénomènes ont lieu, tendant à amplifier de plus en plus la différence de tensions et de courants des deux circuits $L_i C_i$, et à réduire l'ouverture du secteur DOD' (représenté par les doubles flèches aux temps $t_{1\,5}$ et $t_{1\,7}$ sur les figures 9C et 9E).

Ainsi, deux phénomènes différents tendent à amplifier la dissymétrie du capteur engendrée par l'apparition du champ extérieur $H_0$ à l'instant $t_9$ :

1°) l'amplification de la différence de tension de charge de $C_1$ et $C_2$ pendant les oscillations libres (phénomène de pompage) ; et

2°) l'amplification de la différence d'amplitude et de phase des courants de charge de $C_1$ et $C_2$ pendant les phases où le noyau magnétique est désaturé.

L'amplification mentionnée en 1°) s'effectue alors que le matériau magnétique est totalement saturé ; elle bénéficie d'un bruit propre extrêmement faible, car le matériau saturé ne génère plus du tout de bruit de type Barkhausen.

Le bon synchronisme des impulsions positives et négatives du courant d'excitation avec les inversions des tensions de charge des condensateurs $C_1$ et $C_2$ assure l'amplification de la différence de ces tensions de charge et de la différence de phase de ces charges. Le coefficient d'amplification que l'on peut obtenir avec ce système dépend essentiellement des phases respectives du courant d'excitation et des deux tensions de charge des condensateurs. Ce coefficient peut être ajusté entre 1 si par exemple l'inversion du signal d'excitation survient à l'instant $t_{1\,9}$, et une valeur extrêmement grande si on laisse cette différence de tensions augmenter. Le réglage optimum dépend de la stabilité de l'oscillateur commandant l'excitation ; plus celui-ci est stable en fréquence et en rapport cyclique, plus on peut avoir de gain avec ce procédé. Dans ce but, on utilisera un oscillateur à quartz (stabilité en fréquence) suivi d'un diviseur de fréquence (stabilité en rapport cyclique).

L'amplification de type 2°) présente deux intérêts majeurs.

Premièrement, elle s'effectue essentiellement autour des coudes de saturation et de désaturation du circuit magnétique, ces deux coudes représentant des polarisations magnétiques où les mécanismes d'aimantation se font essentiellement par rotion des moments magnétiques de spin, et non par déplacement des parois de Bloch, générateurs des sauts de Barkhausen.

Deuxièmement, on n'amplifie pas le bruit engendré par le matériau ferromagnétique, comme c'est le cas sur les capteurs fluxgate habituels. Au contraire, on intègre l'énergie de ce bruit pendant la phase où l'on traverse le cycle d'hystérésis (entre les instants $t_0$ et $t_3$ sur la figure 4 par exemple), ce qui tend évidemment à augmenter le rapport signal/bruit (ce bruit pouvant être considéré à valeur moyenne nulle, et de fréquence supérieure à la fréquence d'excitation).

En conséquence, ce deuxième type d'amplification a aussi lieu dans des conditions où le bruit généré est extrêmement faible.

Il résulte de ces deux remarques que la polarisation magnétique originale du détecteur selon l'invention permet d'utiliser un noyau magnétique donné de manière réellement optimale, du point de vue du rapport signal sur bruit. En n'utilisant qu'un matériau magnétique de qualité moyenne on peut assez facilement, de cette manière, atteindre les différences de tensions de charge entre les deux condensateurs d'un volt par nanotesla de champ extérieur avec les bobines $L_1$ et $L_2$ comprenant une centaine de spires.

## 2.2 Régime permanent

En régime établi, si le capteur évolue dans les mêmes conditions (mêmes oscillations du courant d'excitation $I_e$ et même champ extérieur $H_0$), la différence de tension $\delta_1 V(t)$ va, au bout d'un certain nombre de périodes, se stabiliser, ce qui permet de ne pas obtenir un dispositif totalement bistable.

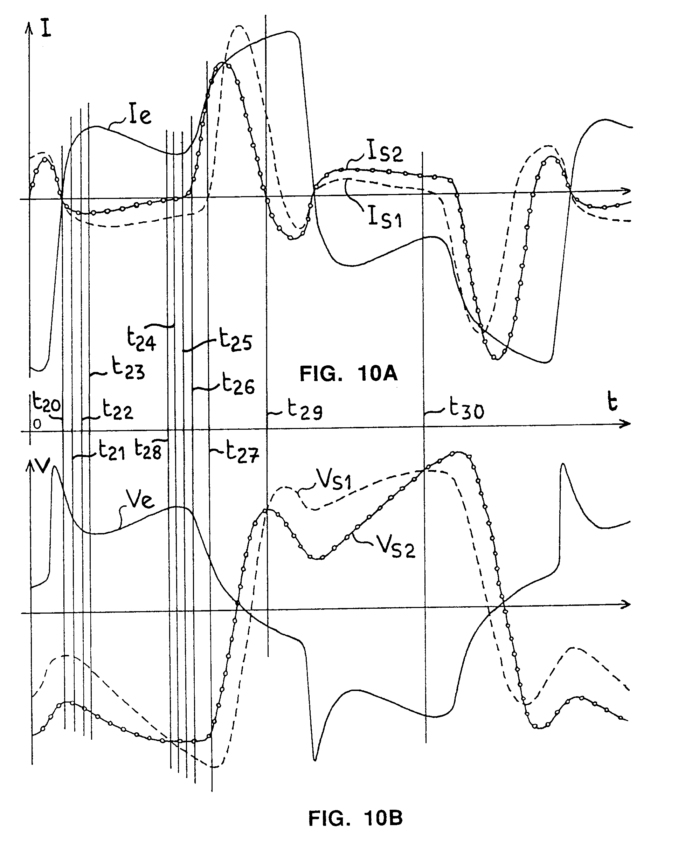

Les figures 10A-10B, 11, et 12A-12H illustrent de manière plus détaillée, le passage des points A et B du circuit magnétique en désaturation (instants compris entre $t_{14}$ et $t_{18}$ sur la figure 7).

Ces figures représentent la suite des figures 7A-7B, 8 et 9A-9F, où le même champ $H_0$ est appliqué au capteur et qu'un certain nombre de périodes s'est écoulé pour amplifier suffisamment la différence des tensions et courants des circuits $L_1 C_1$ et $L_2 C_2$. En pratique, ce nombre de périodes est très faible.

Soit $t_{20}$ l'instant où tous les courants sont à peu près nuls, et où la somme des ampères-tours présents autour du circuit magnétique est nulle. A cet instant, la tension de charge de $C_1$ est inférieure en valeur absolue à celle de $C_2$. Le courant d'excitation tend alors à renverser l'aimantation du circuit magnétique.

A l'instant $t_{21}$ apparaissent le long du circuit magnétique deux petites régions où le matériau magnétique commence à se désaturer. Ces régions ne sont pas situées aux pôles du capteur, car les courants $I_{s1}$ et $I_{s2}$ sont différents, rompant la symétrie de ce capteur. $I_{s1}$ étant plus grand que $I_{s2}$, il tend à maintenir le côté 1 plus longtemps en saturation que le côté 2 ne l'est par $I_{s2}$.

Ces deux régions désaturées s'étendent progressivement le long du circuit magnétique.

A un instant $t_{22}$ le point B est désaturé, et le point A est encore saturé.

A cet instant, le couplage magnétique entre le bobinage d'excitation $L_e$ et le bobinage $L_2$ est complet ; ce couplage étant beaucoup plus fort que du côté n°1, ce sont les ampères-tours démagnétisants de $L_2$ seul qui tendent à s'opposer aux ampères-tours magnétisants du circuit d'excitation, et la différence entre les courants $I_{s1}$ et $I_{s2}$ n'a plus tendance à augmenter.

A partir d'un instant $t_{23}$, tout le circuit magnétique est désaturé, et ceci jusqu'à l'instant $t_{24}$ où les condensateurs $C_1$ et $C_2$ sont rechargés, et leurs courants de charge ne sont plus suffisants pour s'opposer à l'arrivée en saturation positive.

Peu de temps après, à l'instant $t_{25}$, naissent deux régions où le circuit magnétique est saturé en premier. A nouveau, comme $I_{s1}$ et $I_{s2}$ sont différents, ces régions n'apparaissent pas vers les pôles du détecteur. Elles apparaissent du côté n°2 car, le courant $I_{s2}$ étant plus faible qu'$I_{s1}$, il s'oppose moins au courant d'excitation $I_e$ qui tend à entraîner le circuit vers la saturation positive.

Le couplage magnétique entre $L_e$ et $L_1$ est donc encore très grand, alors qu'il est faible entre $L_e$ et $L_2$. Ceci tend à maintenir le côté n°1 un peu plus longtemps en désaturation, donc à amplifier la différence de phase entre le début des oscillations des deux circuits $L_1 C_1$ et $L_2 C_2$.

Ensuite, par exemple à un instant $t_{26}$, le secteur saturé s'allonge et permet à $L_2 C_2$ de démarrer les oscillations libres. Le courant $I_{s2}$ augmente très vite, et crée un champ élevé sur le côté n°1 s'additionnant au champ $H_e$, ceci tendant à saturer la région du point A et à accélérer le passage de $L_1 C_1$ à la phase d'oscillations libres. Ce phénomène tend à réduire la différence de phase entre le début des oscillations libres des deux circuits $L_1 C_1$ et $L_2 C_2$. En effet, le passage d'un des deux circuits en oscillations libres a tendance à favoriser le passage de l'autre circuit dans cette phase.

A un instant $t_{27}$, le circuit magnétique est totalement saturé, et les deux circuits oscillent librement.

En résumé, la différence de couplage magnétique entre $L_e$ et $L_1$ d'une part, et $L_e$ et $L_2$ d'autre part, qui contribuait à l'amplification de la différence des courants lorsque celle-ci était faible, permet de stabiliser cette différence lorsqe celle-ci est importante.

L'ensemble de ces phénomènes d'amplification et de stabilisation permet de linéariser la réponse de ce détecteur autour d'un champ $H_0$ nul, ce qui permet d'envisager son utilisation dans une boucle de contre réaction en champ.

CIRCUITS DE SORTIE D'INFORMATIONS

L'information sur la différence entre les tensions $V_{s\,1}$ et $V_{s\,2}$ peut être exploitée de très nombreuses manières au choix de l'utilisateur du capteur selon la présente invention. L'un des modes d'exploitation de cette différence, fournissant un signal directement proportionnel au champ appliqué au capteur consiste à intégrer sur une période la valeur redressée de cette différence. Comme on le voit en figure 10, la différence des tensions $V_{s\,1}$, $V_{s\,2}$ s'annule à l'instant $t_{2\,8}$, et est ensuite négative pour devenir positive entre des instants $t_{2\,9}$ et $t_{3\,0}$. Le décalage entre les instants $t_{2\,8}$, $t_{2\,9}$ et $t_{3\,0}$ et l'instant d'origine $t_{2\,0}$ est sensiblement constant et sensiblement indépendant de l'intensité du champ magnétique.

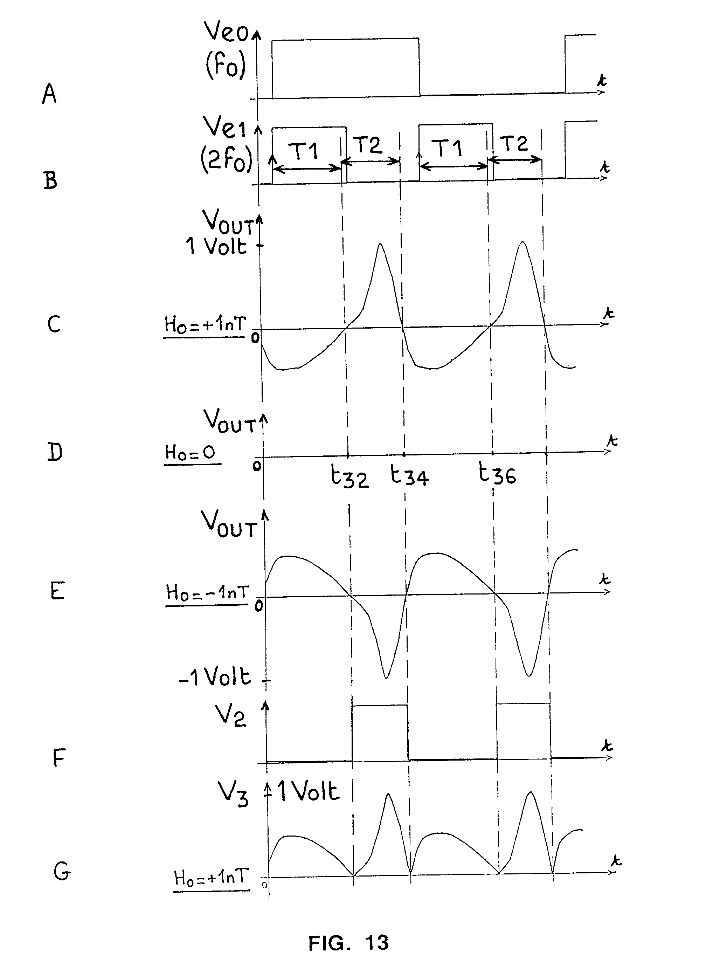

La figure 13 représente en A le signal de commande de l'enroulement d'excitation, $V_{e\,0}$ ; en B un signal à fréquence double, $V_{e\,1}$ ; en C l'allure du signal $V_{o\,u\,t}$ pour un champ détecté positif ayant par exemple une valeur de l'ordre de 1 nT ; en D l'allure de ce signal en l'absence de champ appliqué ; en E l'allure de ce signal pour un champ appliqué de sens opposé à celui illustré en C. Pour redresser le signal correspondant à celui illustré en C, on pourra, en tenant compte du fait que les retards entre les instants $t_{3\,2}$ et $t_{3\,4}$ et $t_{3\,6}$ sont pratiquement constants, utiliser un signal tel que celui illustré en figure 13 courbe F où l'on peut voir des créneaux d'une première polarité entre les instants $t_{3\,2}$ et $t_{3\,4}$, et des créneaux d'une deuxième polarité entre les instants $t_{3\,4}$ et $t_{3\,6}$. En fournissant le signal $V_{o\,u\,t}$ non inversé entre les instants $t_{3\,2}$ et $t_{3\,4}$ et inversé entre les instants $t_{3\,4}$ et $t_{3\,6}$, on obtient un signal de détection tel qu'illustré dans la courbe G de la figure 13. La valeur moyenne de ce signal fournit une indication de la valeur du champ à mesurer $H_0$.

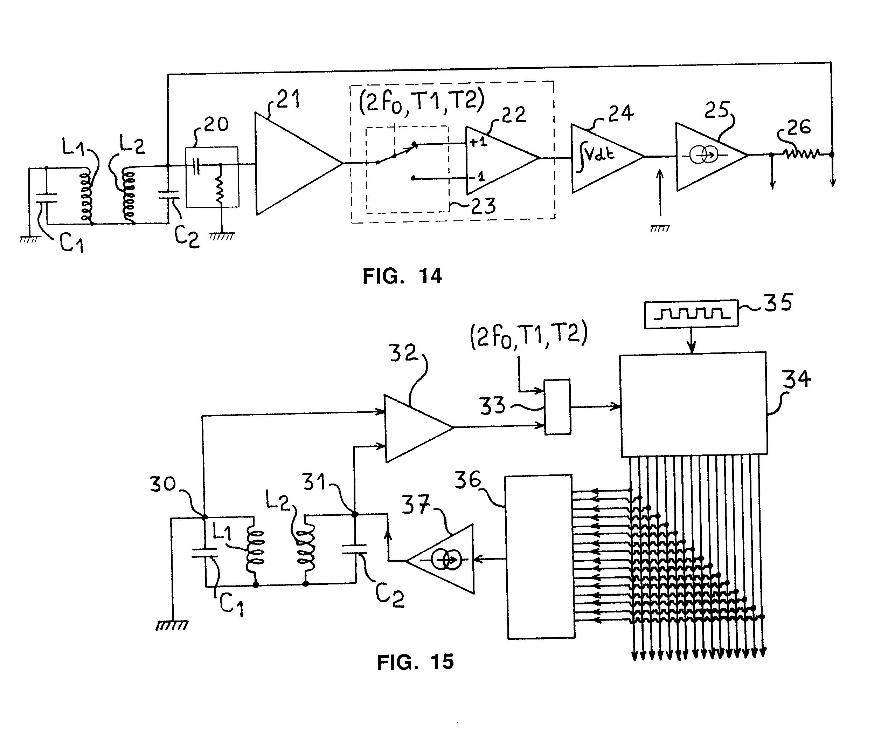

Le circuit illustré en figure 14 permet d'atteindre ce résultat. Les bornes inférieures des condensateurs $C_1$ et $C_2$ des deux circuits résonants $L_1 C_1$ et $L_2 C_2$ sont interconnectées, la borne supérieure du condensateur $C_1$ est reliée à la masse, et la borne supérieure du condensateur $C_2$ fournit le signal de détection qui est appliqué par l'intermédiaire d'un circuit de filtrage 20 à un amplificateur adapteur d'impédance 21. La sortie de l'adapteur 21 est appliquée à la borne d'entrée inverseuse ou non-inverseuse d'un amplificateur 22, la commutation étant assurée par un commutateur 23 actionné au rythme des créneaux illustrés en figure 13F. La sortie de l'amplificateur 22 est intégrée dans un intégrateur 24 et appliquée à un amplificateur de courant 25 dont la sortie est renvoyée sur le point de connexion de l'inductance $L_2$ et du condensateur $C_2$ en tant que courant de contre-réaction. La valeur du champ au niveau du détecteur pourra être fournie par lecture de la tension aux bornes d'une résistance 26 connectée à la sortie de l'amplificateur de courant 25.

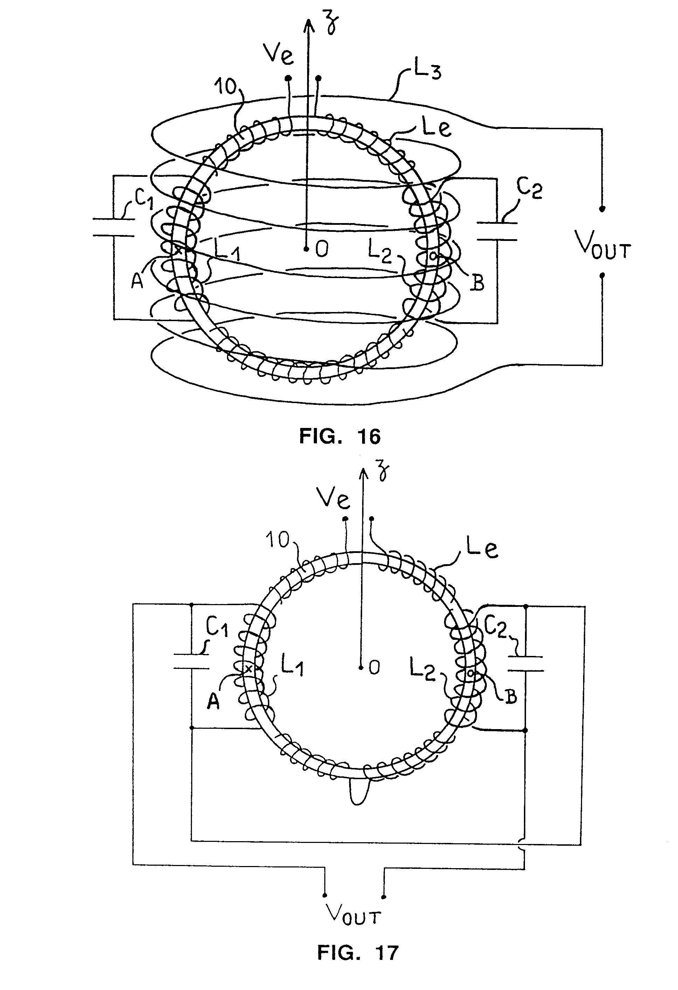

On notera que la détection et la réaction en courant, au lieu de se faire sur les bobinages $L_2$, $L_1$ pourrait se faire sur une bobine auxiliaire, comme illustré sur la figure 16. En plus des deux bobinages $L_1$ et $L_2$ qui seront alors uniquement connectés à leurs condensateurs respectifs $C_1$ et $C_2$, une troisième bobine $L_3$ entourant le circuit magnétique sera seule reliée au montage électronique de détection et de contre réaction.

Le circuit de la figure 15 illustre un mode de mesure numérique du champ. Les sorties 30 et 31 du capteur sont reliées aux entrées d'un comparateur de tension par rapport à une valeur nulle 32, dont la sortie ($\pm 1$ en code binaire) est appliquée à une des deux entrées d'une porte OU Exclusif 33. L'autre entrée de la porte 33 est commandée par les créneaux illustrés en figure 13F, et la sortie logique de la porte 33 est appliquée à l'entrée commandant le comptage/décomptage d'un compteur 34 actionné par une horloge 35. Les sorties du compteur 34 fournissent des informations binaires correspondant à la valeur moyenne du champ $H_0$. Ces sorties sont reliées, par l'intermédiaire d'un convertisseur de tension numérique-analogique 36, à un amplificateur de courant 37 qui assure une contre-réaction sur les enroulements $L_1$, $L_2$.

On notera que les deux types de montages précédemment décrits peuvent être utilisés simultanément sur le même capteur, par exemple avec le circuit de détection et de contre réaction numérique de la figure 15 affecté à une mesure "grossière" du champ $H_0$, et le circuit analogique de la figure 14 dédié à une mesure "fine" du champ $H_0$.

On a décrit précédemment, de façon générale et en relation avec des modes de réalisation particuliers, un capteur de champ magnétique et des systèmes de mesure. A partir de ces explications, les détails de mise en oeuvre apparaîtront clairement à l'homme de l'art qui pourra en outre apporter diverses variantes et modifications à ce qui a été décrit.

Par exemple, pour constituer le noyau magnétique, on pourra réaliser sur un support torique à section en U d'acier inoxydable amagnétique un enroulement de feuillets de mumétal qui présente une perméabilité relative de 100 000. Toutefois, un inconvénient connu d'un tel matériau est que le numétal est sensible à la magnétostriction et que son coefficient de perméabilité relative est susceptible de varier fortement. En outre, des pertes par courant de Foucault apparaissent dans l'acier inoxydable. On pourra donc utiliser préférentiellement un matériau magnétique amorphe qui présente une très faible magnétostriction et dont le coefficient de dilatation est pratiquement nul ce qui permet de l'utiliser sur un support isolant. L'ensemble des rubans constituant le noyau magnétique pourra avoir par exemple une section de 0,2 x 0,08 mm.

Alors que ce circuit magnétique a été décrit comme étant de forme torique, on pourra choisir des circuits magnétiques de forme rectangulaire à coins arrondis ou à bras multiples. La forme de ce circuit et des bobinages d'excitation et de détection associés pourra être choisie pour favoriser une grande variation des coefficients de couplage magnétique entre ces bobinages, pour améliorer le caractère directionnel du détecteur, ou pour réduire encore sa sensibilité à un gradient de champ magnétique.

Dans un mode de réalisation pratique, l'enroulement d'excitation a été bobiné régulièrement sur toute la circonférence du tore magnétique.

Par ailleurs, le nombre de tours de l'enroulement d'excitation sera choisi en fonction du courant d'excitation $I_e$ disponible et du diamètre du tore du circuit magnétique et pourra par exemple être de l'ordre de 2 000 spires pour un diamètre de l'ordre de quelques centimètres.

Le nombre de tours des enroulements détecteurs sera choisi pour permettre d'obtenir un signal suffisamment important tout en maintenant une faible résistance pour que l'amortissement du circuit oscillant constitué par chacun des enroulements détecteurs et son condensateur associé soit faible. Les deux secteurs du tore constituant le circuit magnétique sur lesquels sont bobinés les bobinages $L_1$ et $L_2$ pourront, par exemple, correspondre à un angle de 60° chacun et on pourra par exemple utiliser environ 100 tours d'enroulement avec des condensateurs ayant des valeurs de l'ordre de la centaine de nanofarads.

La fréquence d'excitation du circuit pourra être de l'ordre de 50 kilohertz obtenus par division à partir d'un quartz normalisé à une fréquence de l'ordre de quelques MHz. On notera qu'il est tout particulièrement souhaitable de prévoir une alimentation par quartz pour fixer la fréquence d'excitation car la précision du dispositif dépend du fait que les commutations ont toujours lieu au même emplacement relatif par rapport aux oscillations des circuits résonnants.

D'autre part, un avantage de la présente invention est que, comme les divers circuits électriques sont symétriques, si tous les éléments sont soumis aux mêmes variations et dérives thermiques ou de vieillissement, l'effet de ces dérives sur le fonctionnement sera nul, notamment en ce qui concerne les condensateurs et les inductances.

La structure différentielle et la très grand sensibilité de ce détecteur permettent de construire un gradientmètre tel qu'illustré sur la figure 17 utilisant les principes et le fonctionnement précédemment décrits. Il suffira pour cela de diviser en deux parties égales le bobinage d'excitation $L_e$ suivant l'axe du détecteur, et d'inverser le sens de bobinage sur une moitié de cet enroulement, afin de créer aux points A et B du circuit magnétique des champs d'excitation parallèles (et non pas opposés comme dans le détecteur du magnétomètre), ou d'utiliser un circuit tel que le circuit 3 de la figure 1 comme circuit d'excitation, et d'inverser les sens des connexions des deux circuits $L_1$ $C_1$ et $L_2$ $C_2$, de telle manière que la somme des flux d'excitation et des flux dûs à la composante homogène du champ extérieur $H_0$ embrassée par $L_1$ et $L_2$ s'annule à tout instant. Ainsi, ce détecteur ne sera sensible qu'à la différence des champs extérieurs $H_0$ entre le point A et le point B, donc au gradient magnétique.

## Revendications

1. Capteur de champ magnétique à haute sensibilité comprenant un circuit magnétique à haute perméabilité (10) et des moyens d'excitation ($L_e$) permettant de saturer périodiquement ce circuit magnétique, caractérisé en ce qu'il comprend :
   – deux bobinages identiques ($L_1$, $L_2$) bobinés symétriquement autour de parties symétriques (A, B) du circuit magnétique ;
   – un premier et un second condensateur identiques ($C_1$, $C_2$), respectivement connectés aux bornes de chacun des bobinages, et
   – des moyens ($L_1$, $L_2$ ; $L_3$) de mesure de la différence des flux magnétiques traversant lesdites parties.

2. Capteur de champ magnétique selon la revendication 1, caractérisé en ce que la capacité des condensateurs ($C_1$, $C_2$) est choisie en relation avec la valeur des inductances desdits bobinages ($L_1$, $L_2$) et avec la périodicité du signal d'excitation pour que les deux condensateurs soient chargés par la tension générée aux bornes des bobinages pendant les phases de désaturation du circuit magnétique, que les deux circuits résonants ($L_1$ $C_1$, $L_2$ $C_2$) formés par chaque assemblage d'un condensateur et d'un bobinage entrent en oscillations libres pendant les phases de saturation du circuit magnétique, et que les commutations du signal d'excitation surviennent pendant ces oscillations libres tandis que la différence des tensions aux bornes des bobinages s'est inversée par rapport à la commutation précédente.

3. Capteur de champ magnétique selon la revendication 1, caractérisé en ce que lesdits bobinages sont concentrés vers le plan équatorial du circuit magnétique saturable.

4. Capteur de champ magnétique selon la revendication 1, caractérisé en ce que lesdits moyens de mesure comprennent des moyens de détection d'une tension générée par ladite différence, des moyens de détection synchrone (22, 23) de cette tension fournissant un signal redressé, des moyens d'intégration (24) du signal redressé, et des moyens de réinjection du signal redressé dans les moyens de détection (25, 26).

5. Capteur de champ magnétique selon la revendication 4, caractérisé en ce que les moyens de détection sont constitués par lesdits bobinages ($L_1$, $L_2$).

6. Capteur de champ magnétique selon la revendication 4, caractérisé en ce que les moyens de détection sont constitués par une bobine auxiliaire ($L_3$) entourant l'ensemble du circuit magnétique.

7. Capteur de champ magnétique selon la revendication 1, caractérisé en ce que les moyens d'excitation appliquent à tout instant auxdites parties symétriques des champs parallèles et de même direction, d'où il résulte que le capteur peut fonctionner en gradientmètre.

**FIG. 1**

**FIG. 2B**

**FIG. 2C**

**FIG. 2A**

**FIG. 3**

10

FIG. 4A

FIG. 4B

EP 0 470 915 A1

FIG. 5

FIG. 6A

FIG. 6B

FIG. 6C

FIG. 6D

FIG. 6E

FIG. 6F

FIG. 7A

FIG. 7B

EP 0 470 915 A1

FIG. 8

FIG. 9A

FIG. 9B

FIG. 9C

FIG. 9D

FIG. 9E

FIG. 9F

14

FIG. 10A

FIG. 10B

× 1
○ 2

FIG. 11

$t_{20}$

FIG. 12A

$t_{21}$

FIG. 12B

$t_{22}$

FIG. 12C

$t_{23}$

FIG. 12D

$t_{24}$

FIG. 12E

$t_{25}$

FIG. 12F

$t_{26}$

FIG. 12G

$t_{27}$

FIG. 12H

FIG. 13

FIG. 14

FIG. 15

FIG. 16

FIG. 17

Office européen
des brevets

**RAPPORT DE RECHERCHE EUROPEENNE**

Numero de la demande

EP    91 42 0287

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 045 509 (SIEMENS AKTIENGESELLSCHAFT) * page 3, ligne 19 - page 4, ligne 11; figure 3 * | 1,4,5 | G01R33/04 |
| A | | 2 | |
| A | US-A-4 495 467 (A. KUNO ET AL.) * colonne 2, ligne 9 - ligne 16; figure 1 * | 1,2 | |
| A | DE-A-2 016 662 (ELECTRONIQUE MARCEL DASSAULT) * page 5, ligne 20 - page 6, ligne 11; figure 4 * | 1 | |
| A | IEEE TRANSACTIONS ON MAGNETICS vol. MAG19, no. 2, Mars 1991, NEW YORK, US pages 126 - 130; R. DONCASTER RUSSELL ET AL: 'Characteristics of the Capacitively Loaded Fluxgate Sensor' * page 129, colonne de gauche; figure 3 * | 1 | |

**DOMAINES TECHNIQUES RECHERCHES (Int. Cl.5)**

G01R

Le présent rapport a été établi pour toutes les revendications

| Lieu de la recherche | Date d'achèvement de la recherche | Examinateur |
|---|---|---|
| LA HAYE | 12 NOVEMBRE 1991 | SWARTJES H.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)